# EUROPEAN PATENT APPLICATION

(11) **EP 1 600 813 A1**
(43) Date of publication of application: **30.11.2005**
(21) Application number: 04717245.7
(22) Date of filing: 04.03.2004
(51) Int. Cl.: G03F 7/038, G03F 7/004, C08F 20/04, C08F 20/26

(54) **RESIST MATERIAL FOR LIQUID IMMERSION EXPOSURE PROCESS AND METHOD OF FORMING RESIST PATTERN WITH THE RESIST MATERIAL**

(30) Priority: 04.03.2003 JP 2003057766; 28.03.2003 JP 2003092769
(71) Applicant: TOKYO OHKA KOGYO CO., LTD., Kawasaki-shi Kanagawa 211-0012 (JP)
(72) Inventor: IWASHITA, Jyun, c/o Tokyo Ohka Kogyo Co., Ltd., Kawasaki-shi, Kanagawa 2110012 (JP); HIRAYAMA, Taku, c/o Tokyo Ohka Kogyo Co., Ltd., Kawasaki-shi, Kanagawa 2110012 (JP); TACHIKAWA, Toshikazu, Tokyo Ohka Kogyo Co., Ltd., Kawasaki-shi, Kanagawa 2110012 (JP)
(74) Representative: HOFFMANN EITLE
(86) International application number: PCT/JP2004/002752
(87) International publication number: WO 2004/079453

(57) **Abstract**

A negative resist material for a liquid immersion lithography process containing a resin component and a crosslinker component for this resin component, wherein the crosslinker component is poorly soluble in a liquid immersion medium, and a method for forming a resist pattern by the use thereof are provided. These simultaneously prevent alteration of a resist film and alteration of the liquid used during the liquid immersion lithography and enable to form the resist pattern with high resolution using the liquid immersion lithography. In the liquid immersion lithography process, the resolution of the resist pattern is enhanced by exposing the resist film to light with the intervening liquid with a predetermined thickness whose refractive index is higher than that of air and lower than that of the resist film on at least the resist film in a path of lithography exposure light reaching the resist film.

## Description

### TECHNICAL FIELD

The present invention relates to a resist material which is preferable for obtaining a resist film used for a liquid immersion lithography process, in particular, the liquid immersion lithography process in which a resolution of the resist pattern is enhanced by exposing the resist film to light with an intervening liquid with a predetermined thickness whose refractive index is higher than that of air and lower than that of the resist film on at least the resist film in a path of the lithography exposure light reaching the resist film, and a method for forming a resist pattern using the resist material.

### BACKGROUND ART

Lithographic methods are frequently used for manufacturing fine structures in various electronic devices such as semiconductor devices and liquid crystal devices, and microfabrication is also required for resist patterns in lithographic processes along with the microfabrication of device structures.

Currently, it is possible to form the fine resist pattern having a line width of about 90 nm by the lithographic method in the most advanced area, and a finer pattern formation will be required in the future.

For accomplishing to form such a finer pattern than 90 nm, development of an exposure apparatus and a resist accepted by the apparatus is the first point. In the exposure apparatus, shortening of a wavelength of a light source such as F₂ laser, EUV (extreme ultraviolet radiation), electron ray and X-ray, and increase of numerical aperture (NA) in a lens are common developmental points.

However, the shortening of the wavelength of the light source requires an expensive new apparatus. In the increase of the numerical aperture, there is a problem that even when the resolution is increased, a focal depth range is decreased because the resolution and the focal depth range are in trade-off relationship.

Recently, a method called a liquid immersion lithographic method has been reported as a lithographic technology which enables to solve such problems (e.g., Non-patent Document 1 [J. Vac. Sci. Technol. B, 17(6):3306-3309, 1999], Non-patent Document 2 [J. Vac. Sci. Technol. B, 19(6):2353-2356, 2001], Non-patent Document 3 [Proceedings of SPIE Vol. 4691:459-465, 2002]). This method allows purified water or a liquid refractive index medium (immersion liquid) such as fluorine-based inert liquid having a predetermined thickness to intervene on at least a resist film between a lens and the resist film on a substrate at the exposure. In this method, exposure light path space which has been conventionally occupied by inert gas such as air and nitrogen is replaced with a liquid such as purified water whose refractive index (n) is larger. Therefore, even when the light source with the same exposure wavelength is used, the high resolution is accomplished as well as the focal depth range is not decreased as is the case with the use of the light source with shorter wavelength or the lens with high NA.

If such a liquid immersion lithography is used, the resist pattern which is excellent in high resolution and focal depth may be formed with low cost using the lens mounted in the existing apparatus. Thus, the liquid immersion lithography is now remarkably noticed.

### DISCLOSURE OF INVENTION

In the aforementioned liquid immersion lithography process, inert water such as purified water and deionized water, and perfluoroether have been proposed as the immersion liquid used, and the inert water has appeared to be promising in terms of cost and easy handling. However, a resist film is invaded by the immersion liquid because the resist film is directly contacted with the immersion liquid at the exposure. Therefore, in order to put the aforementioned new lithographic technology to practical use, it is necessary to provide a resist material capable of forming a resist film having high resistance to the immersion liquid.

The present invention has been made in the light of the above circumstance, and it is an object of the invention to provide a negative resist material which is suitably used for the liquid immersion lithography process which is the new lithographic technology, and a method for forming a resist pattern using this negative resist material.

To achieve the object, a negative resist material for a liquid immersion lithography process of the present invention is characterized in comprising a resin component and a crosslinker component for this resin component and said crosslinker component is poorly soluble in a liquid immersion medium.

The method for forming a resist pattern of the present invention is a method for forming a resist pattern using a liquid immersion lithography process comprising forming at least a photoresist film on a substrate using the resist material; directly arranging an immersion liquid on said substrate on which said resist film has been laminated; irradiating predetermined pattern light onto said resist film through said immersion liquid and if necessary giving a baking treatment; removing said immersion liquid from the resist film after said irradiation; and developing the resist film from which said immersion liquid has been removed to obtain the resist pattern.

In the above invention, it is preferable to enhance the resolution of the resist pattern by exposing a resist film to light with an intervening liquid with a predetermined thickness whose refractive index is higher than that of air and lower than that of the resist film on at least the resist film in a path of the lithography exposure light reaching the resist film.

When the present invention was made, the present inventors analyzed a method for evaluating qualification of the resist film used for the liquid immersion lithography process as follows, and the negative resist material and the method for forming the resist pattern using this negative resist material were evaluated based on the analysis results.

That is, in order to evaluate performance of the resist pattern formation by the liquid immersion lithography, it is considered that it is necessary and sufficient to identify the following three points: (i) the performance of an optical system by the liquid immersion lithography method, (ii) an influence from the resist film on the immersion liquid, and (iii) an alteration of the resist film by the immersion liquid.

For the performance of the optical system (i), for example, as is evident from assuming that a photosensitive plate with waterproof surface for a photograph is immersed in water and pattern light is irradiated to the surface, it is no doubt in principle that there is no problem if there is no light propagation loss such as reflection in a water surface and an interface between the water and the surface of the photosensitive plate. In this case, the light propagation loss is easily solved by correcting an incident angle of the exposure light. Therefore, whether an exposed subject is the resist film or the photosensitive plate for photograph or an image formation screen, if they are inert for the immersion liquid, i.e., if they are not affected by the immersion liquid and do not affect the immersion liquid, it can be considered that no change occurs in the performance of the optical system. Therefore, it is not necessary to perform a new experiment on this point.

The influence of the resist film on the immersion liquid (ii) specifically indicates that a component in the resist film is dissolved out in the liquid to change the refractive index of the liquid. It is theoretically evident without need of an experiment that the optical resolution of pattern exposure is changed if the refractive index of the liquid is changed. On this point, it is sufficient to identify the change of the immersion liquid composition or the change of the refractive index by the dissolution of the component when the resist film is immersed in the liquid, and it is not necessary to identify the resolution by actually irradiating the pattern light and developing.

Conversely to this, when the resolution is identified by irradiating the pattern light to the resist film in the liquid and developing, it is possible to check quality of the resolution, but it can not be distinguished whether the influence on the resolution is attributed to the alteration of the immersion liquid or the alteration of the resist material or both thereof.

For the point that the resolution is deteriorated by the alteration of the resist film caused by the immersion liquid (iii), it is sufficient to perform an evaluation test that "the resist film is showered with the immersion liquid after the exposure, and subsequently developed to inspect the resolution of the resulting resist pattern". And, in this evaluation method, the liquid is directly sprinkled on the resist film and a liquid immersion condition is extremer. On such a point, in the test where the exposure is performed by completely immersing, it does not become clear whether the change of the resolution is attributed to the alteration of the immersion liquid or the alteration of the resist composition by the immersion liquid or both thereof.

The above phenomena (ii) and (iii) are phenomena with two sides of the same coin, and may be figured out by identifying an alteration level of the resist film by the liquid.

Based on such analyses, the qualification for the liquid immersion lithography of the resist film by the new resist material preferable for the liquid immersion lithography process has been identified by the evaluation test that "the resist film is showered with the immersion liquid (purified water) after the exposure, and subsequently developed to inspect the resolution of the resulting resist pattern". The immersion liquid used for this test was the purified water expected in terms of low cost and easy handling. As the other evaluation method, "a constitution where the pattern light of the exposure is substituted with interference light by a prism and a sample is exposed in liquid immersion (two-beam interference exposure method)" was also employed to evaluate.

### BEST MODES FOR CARRYING OUT THE INVENTION

A resist material for the liquid immersion lithography process according to the present invention is characterized in that a resin component and a crosslinker component of this resin component are contained and the crosslinker component is poorly-soluble in a liquid immersion medium.

In the liquid immersion lithography process of the invention, it is preferable that the resolution of a resist pattern is enhanced by exposing a resist film to light with an immersion liquid with a predetermined thickness whose refractive index is higher than that of air and lower than that of the resist film on at least the resist film in a path of the lithography exposure light reaching the resist film.

The resin component above is not limited as long as it is the resin component used for common negative resist compositions, but the followings are preferable. A resin (A) which is a resin component which becomes alkali-insoluble by an acid and has two functional groups in the molecule capable of forming ester by reacting one another, where the groups are dehydrated and form the ester to become alkali-insoluble by an effect of the acid generated by an acid generator simultaneously added in the resist material is preferably used. Herein, the two functional groups capable of forming the ester by reacting one another mean, for example a hydroxyl group and a carboxyl group for forming carboxylate ester or carboxylate ester. In other words, they are the two functional groups for forming the ester. As such a resin, those having a hydroxyalkyl group and at least one of the carboxyl group or the carboxylate ester group in side chains of a resin main skeleton are preferable. Furthermore, a resin component (B) composed of a polymer having a unit of dicarboxylic acid monoester is preferable.

The resin component (A) is, in other words, the resin component having at least a monomer unit represented by the following general formula (2): 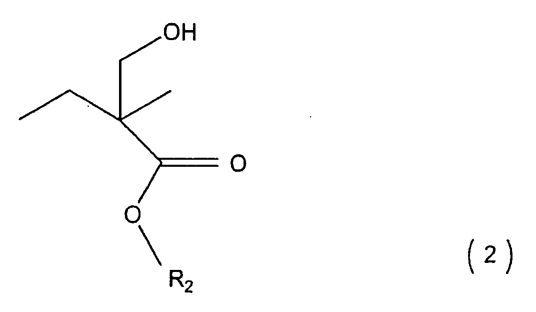 wherein R₂ is a hydrogen atom, a C1 to C6 alkyl group or an alkyl group having a polycyclic ring skeleton such as bornyl, adamantyl, tetracyclododecyl and tricyclodecyl groups.

Examples of such resins may preferably include (A-1) a polymer (homopolymer or copolymer) of at least one monomer selected from α-(hydroxyalkyl) acrylic acid and an alkyl ester of α-(hydroxyalkyl)acrylic acid, and (A-2) a copolymer of at least one monomer selected from α-(hydroxyalkyl)acrylic acid and an alkyl ester of α-(hydroxyalkyl) acrylic acid with at least one monomer selected from other ethylenic unsaturated carboxylic acid and ethylenic unsaturated carboxylate ester.

As the polymer (A-1), the copolymer of α-(hydroxyalkyl)acrylic acid and the alkyl ester of α-(hydroxyalkyl)acrylate is preferable, and as the copolymer (A-2), those using at least one selected from acrylic acid, methacrylic acid, alkyl acrylate and alkyl methacrylate as the other ethylenic unsaturated carboxylic acid and ethylenic unsaturated carboxylate ester are preferable.

Examples of the hydroxyalkyl group in the α-(hydroxyalkyl)acrylic acid and the alkyl ester of α-(hydroxyalkyl)acrylic acid may include lower hydroxyalkyl groups such as hydroxymethyl, hydroxyethyl, hydroxypropyl and hydroxybutyl groups. Among them the hydroxyethyl group and the hydroxymethyl group are preferable in terms of easiness to form the ester.

Examples of the alkyl group in an alkyl ester moiety of the alkyl ester of α-(hydroxyalkyl)acrylic acid may include lower alkyl groups such as methyl, ethyl, propyl, isopropyl, n-butyl, sec-butyl, tert-butyl and amyl groups, and crosslinked polycyclic hydrocarbon groups such as bicyclo[2.2.1]heptyl, bornyl, adamantyl, tetracyclo[4.4.0.1^{2.5}.1^{7.10}]dodecyl and tricyclo[5.2.1.0^{2.6}] decyl groups. Those where the alkyl group in the ester moiety is the polycyclic hydrocarbon group are effective for enhancing dry-etching resistance. In these alkyl groups, particularly the lower alkyl groups such as methyl, ethyl, propyl and butyl are preferable because those which are inexpensive and easily available may be used as an alcohol component for forming the ester.

In the lower alkyl ester, esterification with the hydroxyalkyl group occurs as with the carboxylic group whereas in the ester with the crosslinked polycyclic hydrocarbon, such esterification is difficult to occur. Thus, when the ester with the crosslinked polycyclic hydrocarbon is introduced into the resin, it is preferable to simultaneously have the carboxylic group in the side chain of the resin.

Meanwhile, examples of the other ethylenic unsaturated carboxylic acid and ethylenic unsaturated carboxylate ester in the resin (A-2) may include unsaturated carboxylic acids such as acrylic acid, methacrylic acid, maleic acid and fumaric acid, and alkyl esters such as methyl ethyl, propyl, isopropyl, n-butyl, isobutyl, n-hexyl and octyl esters of these unsaturated carboxylic acids. Acrylate or methacrylate ester having the crosslinked polycyclic hydrocarbon group such as bicyclo[2.2.1]heptyl, bornyl, adamantyl, tetracyclo[4.4.0.1^{2.5}1^{7.10}] dodecyl and tricyclo [5.2.1. 0^{2.6}] decyl groups as the alkyl group in the ester moiety may also be used. Among them, acrylic acid, methacrylic acid or lower alkyl esters such as methyl, ethyl, propyl and n-butyl esters thereof are preferable because they are inexpensive and easily available.

In the resin (A-2), a ratio of at least one monomer unit selected from α-(hydroxyalkyl) acrylic acid and the alkyl ester of α-(hydroxyalkyl)acrylic acid to at least one monomer unit selected from other ethylenic unsaturated carboxylic acid and ethylenic unsaturated carboxylate ester is in the range of 20: 80 to 95:5, and preferably 50:50 to 90:10 at a molar ratio. When the both units are in the above range, the ester is easily formed in the molecule or between the molecules, and a preferable resist pattern is obtained.

The resin component (B) has at least one monomer unit represented by the following general formula (3) or (4): 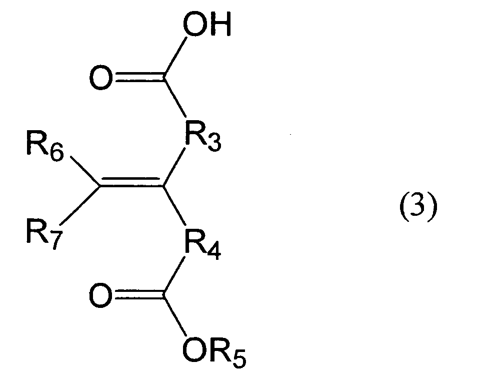 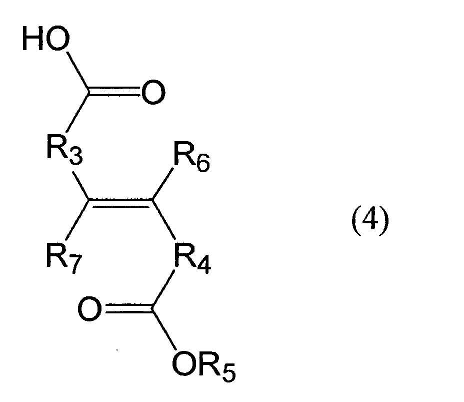 wherein R₃ and R₄ represent alkyl chains having 0 to 8 carbon atoms, R₅ represents a substituent having at least two or more alicyclic structures, R₆ and R₇ represent hydrogen atoms or alkyl groups having 1 to 8 carbon atoms. A negative resist composition using the resin component having such a monomer unit of dicarboxylic acid monoester is preferable because the resolution is high and line edge roughness is reduced, and more preferable in the liquid immersion lithography process because swelling resistance is high.

The substituent R₅ in the above general formula (3) and (4) has at least two or more alicyclic structures, may have two or more alicyclic structures independently in the substituent, and may have them in a form of a condensed ring or a spiro ring. Employment of such a substituent with large carbon density is preferable because the etching resistance of the polymer is enhanced.

A specific example of such a substituent having at least two or more alicyclic structures is preferably at least one selected from the group consisting of adamantane, tricyclodecane, isobornyl, norbornene, adamantane alcohol, norbornene lactone, or derivatives thereof.

As such dicarboxylic acid monoester compounds, monoester of fumaric acid and monoester of itaconic acid are particularly preferable. Specific examples thereof may include monoadamantyl fumarate, monomethyladamantyl fumarate, monoethyladamantyl fumarate, monoisobornyl fumarate, mononorbornyl fumarate, dicyclopentenyl fumarate, dicyclopentanyl fumarate, monoadamantyl itaconate, monomethyladamantyl itaconate, monoethyladamantyl itaconate, monoisobornyl itaconate, mononorbornyl itaconate, dicyclopentenyl itaconate and dicyclopentanyl itaconate.

As the dicarboxylic acid monoester compounds other than the above, monoester compounds derived from mesaconic acid, glutaconic acid and traumatic acid may also be used.

Furthermore, the resin having the unit of the dicarboxylic acid monoester mentioned above may preferably include (B-1) a polymer or a copolymer of a dicarboxylic acid monoester monomer, and (B-2) a copolymer of a dicarboxylic acid monoester monomer with at least one monomer selected from aforementioned α-(hydroxyalkyl) acrylic acid, the alkyl ester of α-(hydroxyalkyl) acrylic acid, other ethylenic unsaturated carboxylic acid and ethylenic unsaturated carboxylate ester.

In the present invention, these resin components may be used alone or in combination of two or more. A weight average molecular weight of the resin component is 1,000 to 50,000 and preferably 2,000 to 30,000.

As a crosslinker component poorly-soluble in the liquid immersion medium which is an important constituent element of the resist material for the liquid immersion lithography process according to the present invention, it is preferable to use a crosslinker having at least three or more crosslink-forming functional groups per molecule and where the crosslink-forming functional group having a nitrogen atom is one or less. Among others, a glycoluril derivative is preferable. In particular, it is preferable to be the structure represented by the following general formula (1): 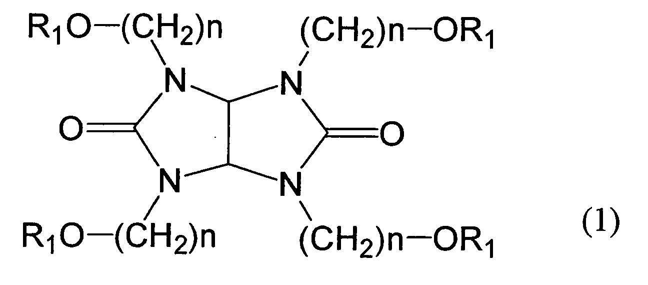 wherein R₁ is an alkyl group having 1 to 10 carbon atoms, and n is 1 to 5 alkyl chains.

As the glycoluril derivative (poorly-soluble crosslinker in the liquid immersion medium) represented by the above general formula (1), butoxymethylated glycoluril is the most preferable.

As an acid generator used for the resist material of the present invention, i.e., a compound which generates an acid by receiving the exposure light, it is possible to appropriately select from and use publicly known acid generators used in conventional chemically amplified negative photo resists, and an onium salt containing alkyl or halogen substituted alkyl sulfonate ion as anion is particularly preferable. Examples of cation of this onium salt may preferably include phenyl iodonium, sulfonium and dimethyl(4-hydroxynaphthyl)sulfonium which may be substituted with lower alkyl groups such as methyl, ethyl, propyl, n-butyl and tert-butyl, and lower alkoxy groups such as methoxy and ethoxy.

Meanwhile, as the anion, fluoroalkyl sulfonate ion where a part of or all hydrogen atoms in the alkyl group having 1 to 10 carbon atoms are substituted with fluorine atoms is preferable, and the fluoroalkyl sulfonate ion where all hydrogen atoms in the alkyl group having 1 to 5 carbon atoms are substituted with the fluorine atoms is preferable because the longer the carbon chain is and the smaller a fluorinated ratio (ratio of fluorine atoms in alkyl group) is, the more an intensity as sulfonic acid is lowered.

Examples of such onium salts may include trifluorometanesulfonate or nonafluorobutanesulfonate of diphenyliodonium, trifluorometanesulfonate or nonafluorobutanesulfonate of bis(4-tert-butylphenyl)iodonium, trifluorometanesulfonate or nonafluorobutanesulfonate of triphenylsulfonium, trifluorometanesulfonate or nonafluorobutanesulfonate of tri(4-methylphenyl)sulfonium, trifluorometanesulfonate or nonafluorobutanesulfonate of dimethyl(4-hydroxynaphthyl)sulfonium. In the present invention, the acid generator of this component (A) may be used alone or in combination of two or more.

In the resist material of the present invention, miscible additives, e.g., an additive resin, a plasticizer, a stabilizer, a coloring agent, a surfactant and amines commonly used for improving the performance of the resist film may further be added if desired.

It is preferable that the resist material of the present invention is used in a form of a solution in which the above components are dissolved in a solvent when used. Examples of such a solvent may include ketones such as acetone, methyl ethyl ketone, cyclohexanone, methyl isoamyl ketone and 2-heptane; polyvalent alcohols and derivatives thereof such as ethylene glycol, ethylene glycol monoacetate, diethylene glycol, diethylene glycol monoacetate, propylene glycol, propylene glycol monoacetate, dipropylene glycol or dipropylene glycol monoacetate, or monomethyl ether, monoethyl ether, monopropyl ether, monobutyl ether or monophenyl ether thereof; cyclic ethers such as dioxane; esters such as methyl lactate, ethyl lactate, methyl acetate, ethyl acetate, butyl acetate, methyl pyruvate, ethyl pyruvate, methyl methoxypropionate and ethyl ethoxypropionate; and amide based solvents such as N,N-dimethylformamide, N,N-dimethylacetamide and N-methyl-2-pyrrolidone. These may be used alone or in mixture of two or more.

The immersion liquid used for the liquid immersion lithography process using the resist material of the present invention may include water composed of purified water and deionized water, and liquids composed of fluorine-based solvents.

Subsequently, the method for forming the resist pattern by the liquid immersion lithography method using the immersion liquid of the present invention will be described.

First, the aforementioned resist material is applied on a substrate such as silicon wafer using a spinner, and subsequently pre-baking (PAB treatment) is performed.

Abilayer laminate may also be made by providing an organic or inorganic anti-reflection film between the substrate and a coating layer of the resist composition.

Steps up to here may be performed using well-known techniques. It is preferable to appropriately set manipulation conditions depending on a composition and a property of the resist composition used.

Subsequently, the substrate on which the resist film has been formed is immersed in the immersion liquid such as "inert water such as purified water and deionized water and a fluorine-based solvent such as perfluoroether and perfluoroalkylamine".

This immersed resist film on the substrate is selectively exposed through a desired mask pattern. Therefore, at that time, the exposed light passes through the immersion liquid to reach the resist film.

At that time, the resist film is directly contacted with the immersion liquid, but the resist film is not altered, the immersion liquid is not altered by the resist film and consequently the optical property such as refractive index thereof is not altered because the resist film is composed of the resist material according to the present invention and resistance to the immersion liquid including the water is high.

In this case, the wavelength used for the exposure is not particularly limited, and the exposure may be performed using radiation rays such as ArF excimer laser, KrF excimer laser, F₂ laser, EUV (extreme ultraviolet radiation), VUV (vacuum ultraviolet radiation), electron ray, X-ray and soft X-ray. The negative resist material of the present invention is preferable particularly when using the ArF excimer laser as the exposure light.

When an exposure step of the immersed resist film using the immersion liquid is completed, the substrate is taken out from the immersion liquid, which is then removed from the substrate.

Then, PEB (post-exposure baking) is given to the exposed resist film, which is subsequently developed using an alkali developer composed of an alkali aqueous solution. The post-exposure baking may be given following to the development. Preferably, the substrate is rinsed using the purified water. This rinse with water is performed by dropping or spraying the water on the substrate surface with rotating the substrate to wash out the developer and the resist composition dissolved with the developer on the substrate. Then, a resist pattern where the resist film has been patternized in accordance with the mask pattern is obtained by drying.

By forming the resist pattern in this way, it is possible to produce the resist pattern having a fine line width, particularly a line and space pattern with small pitch which shows the good resolution.

Herein, the pitch in the line and space pattern refers to a total distance of a resist pattern width and a space width in a line width direction of the pattern.

### EXAMPLES

Examples of the present invention will be described below, but these Examples are only exemplifications for suitably describing the invention and do not limit the invention. In the following description, Comparative Example is also described with Examples.

### (Example 1)

A negative resist material whose solid weight was 8.1% by weight was prepared by dissolving a resin component having a repeat unit represented by the following chemical formula (5) : 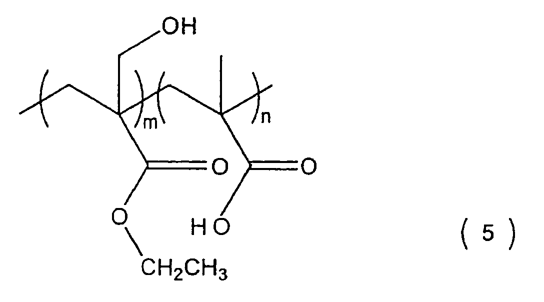 wherein m:n is 84:16 (mol%), 10% by weight of a water-poorly soluble crosslinker composed of tetrabutoxymethylated glycoluril, 1% by weight of an acid generator composed of triphenylsulfonium nonafluorobutanesulfonate and 0.6% by weight of an amine component composed of 4-phenylpyridine based on the weight of the resin component in propylene glycol monomethyl ether.

On the other hand, an organic anti-reflection film with a thickness of 82 nm was formed by applying the organic anti-reflection film "AR-19" (trade name, supplied from Shipley) on a silicon wafer which was a substrate using a spinner and baking at 215°C for 60 seconds on a hotplate to dry. A resist film with a thickness of 250 nm was formed on this anti-reflection film by applying the aforementioned negative resist material on the anti-reflection film using the spinner and baking at 110°C for 60 seconds to dry.

Immersion exposure was given to the above substrate using "a two-beam interference exposure apparatus (experimental apparatus supplied from Nikon Corporation) which simulated pattern exposure light by irradiating two-beam interference light through a prism" and using purified water as an immersion liquid and ArF excimer laser with a wavelength of 193 nm as a light source. A bottom of the prism in the apparatus used was contacted with the resist film through the purified water.

After the exposure, a PEB treatment at 110°C for 60 seconds was given to the resist film, which was then developed with an alkali developer at 23°C for 40 seconds. An aqueous solution of 2.38% by weight of tetramethylammonium hydroxide was used as the alkali developer.

A resist pattern having 90 nm line-and-space at 1:1 obtained in this way was observed by a scanning electron microscope (SEM), and consequently, the pattern was preferable because no pattern defect such as swelling was observed in its profile.

### (Example 2)

A resist pattern was obtained by employing the aforementioned evaluation test that "the resist film is showered with the immersion liquid (purified water) after the exposure, and subsequently developed to inspect the resolution of the resulting resist pattern", giving the exposure using a substrate with the same constitution as in Example 1 and using the same light source as in Example 1, showering with the purified water for 120 seconds, and subsequently performing the PEB treatment and development in the same way as in Example 1.

The resist pattern having 160 nm line-and-space at 1:1 obtained in this way was observed by the scanning electron microscope (SEM), and consequently, the pattern was preferable because no pattern defect such as swelling was observed in its profile. The sensitivity at that time was 30.7 mJ/cm². Meanwhile, when a resist pattern was formed using the resist material in Example 2 by the conventional formation method without giving the showering treatment, the sensitivity was 30.1 mJ / cm2 . A ratio of the sensitivity in the liquid immersion lithography to the sensitivity in the standard technique was 101.9.

### (Example 3)

A negative resist material whose solid weight was 7.0% by weight was prepared by dissolving a resin component having a repeat unit represented by the following chemical formula (6) : 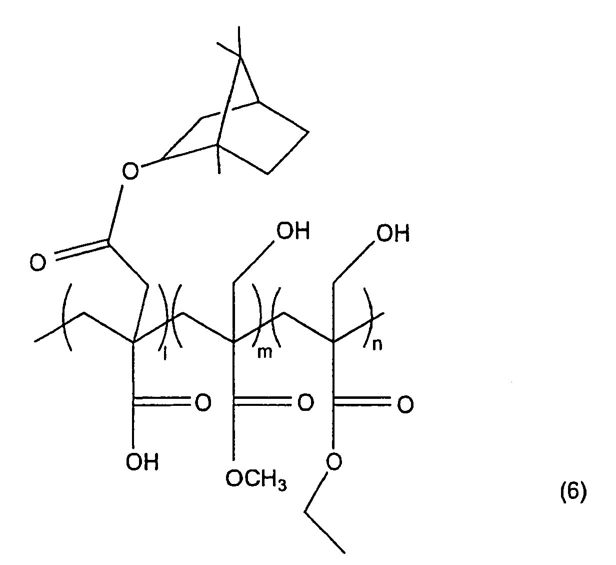 wherein 1:m:n is 12:44:44 (mol%), 10% by weight of a water-poorly soluble crosslinker composed of tetrabutoxymethylated glycoluril, 1.5% by weight of an acid generator composed of triphenylsulfonium perfluorobutanesulfonate and 0.2% by weight of an amine component composed of triethanolamine based on the weight of the resin component in propylene glycol monomethyl ether.

On the other hand, an organic anti-reflection film with a thickness of 82 nm was formed by applying the organic anti-reflection film "AR-19" (trade name, supplied from Shipley) on a silicon wafer which was a substrate using the spinner and baking at 215°C for 60 seconds on the hotplate to dry. A resist film with a thickness of 150 nm was formed on this anti-reflection film by applying the aforementioned negative resist material on the anti-reflection film using the spinner and baking at 140°C for 60 seconds to dry.

Immersion exposure was given to the above substrate using "a two-beam interference exposure apparatus (experimental apparatus supplied from Nikon Corporation) which simulated pattern exposure light by irradiating two-beam interference light through a prism" and using purified water as the immersion liquid and ArF excimer laser with a wavelength of 193 nm as the light source. A bottom of the prism in the apparatus used was contacted with the resist film through the purified water.

After the exposure, a PEB treatment at 130°C for 60 seconds was given to the resist film, which was then developed with an alkali developer at 23°C for 60 seconds. An aqueous solution of 2.38% by weight of tetramethylammonium hydroxide was used as the alkali developer.

A resist pattern having 90 nm line-and-space at 1:1 obtained in this way was observed by the scanning electron microscope (SEM), and consequently, the pattern was preferable because no pattern defect such as swelling was observed in its profile.

A line edge roughness (LER) of this resist pattern similarly observed by the SEM was 4.2 nm.

### (Reference Example 1)

A resist pattern having 160 nm line-and-space at 1:1 was obtained by using the same resist material as in Example 1 but giving dry exposure (exposure apparatus: NSR-s302 inline supplied from Nikon Corporation) through a standard mask pattern without performing the immersion exposure. The line edge roughness observed at that time was 5.2 nm.

### (Comparative Example 1)

A resist pattern having 160 nm line-and-space at 1: 1 was attempted to be formed by the same way as in Example 1 except that the crosslinker was changed to trimethoxymethylated melamine, but intensive pattern swelling occurred.

As described in the above, according to the present invention,
(i) the negative resist pattern with high resolution may be obtained by applying the negative resist material containing the resin component and the crosslinker which is poorly soluble in the liquid immersion medium to the liquid immersion lithography process;
(ii) the negative resist pattern whose shape is preferable may be obtained in the liquid immersion lithography process by using the crosslinker which is poorly soluble in the liquid immersion medium;
(iii) it is possible to control sensitivity variation in the liquid immersion lithography to within ±5% for the sensitivity in the standard dry process; and
(iv) it is possible to further reduce the line edge roughness compared with the resist pattern formation by the standard process.

That is, according to the present invention, the resist film which is highly resistant to the immersion liquid including the water may be formed. Therefore, there is no defective phenomenon such as roughness of the resist pattern surface where the resist pattern becomes a T-top shape, fluctuation of the pattern and spinnable phenomenon in the liquid immersion lithography process. Thus, the resist pattern with high sensitivity and precision which is excellent in resist pattern profile may be obtained. Accordingly, by the use of the negative resist material of the present invention, it is possible to effectively form the resist pattern using the liquid immersion lithography process.

### REFERENCES

1. Journal of Vacuum Science & Technology B(published in USA), Vol. 17 (6) :3306-3309, 1999
2. Journal of Vacuum Science & Technology B(published in USA), Vol. 19(6):2353-2356, 2001
3. Proceedings of SPIE (published in USA), Vol. 4691:459-465, 2002.

## Claims

1. A negative resist material for a liquid immersion lithography process, wherein a resin component and a crosslinker component for this resin component are contained and said crosslinker component is poorly soluble in a liquid immersion medium.

2. The negative resist material for the liquid immersion lithography process according to claim 1, wherein the liquid immersion lithography process comprises exposing a resist film to light with an intervening immersion liquid with a predetermined thickness on at least the resist film in a path of lithography exposure light reaching the resist film, a refractive index of said immersion liquid being higher than that of air and lower than that of the resist film, for enhancing a resolution of a resist pattern.

3. The negative resist material for the liquid immersion lithography process according to claim 1, wherein said crosslinker component is poorly soluble in water.

4. The negative resist material for the liquid immersion lithography process according to claim 3, wherein said water-poorly soluble crosslinker component has at least three or more crosslink-forming functional groups per molecule, one or less of said functional groups being a crosslink-forming functional group having a nitrogen atom.

5. The negative resist material for the liquid immersion lithography process according to claim 4, wherein said water-poorly soluble crosslinker component is a glycoluril derivative.

6. The negative resist material for the liquid immersion lithography process according to claim 5, wherein said glycoluril derivative has a structure represented by the following general formula (1): 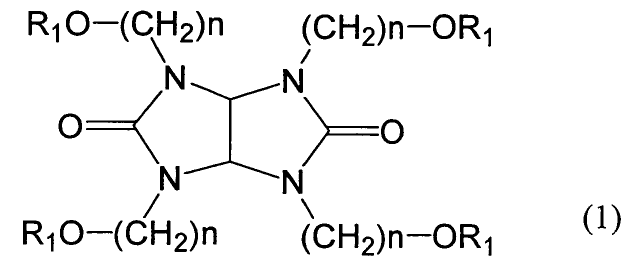 wherein R₁ is an alkyl group having 1 to 10 carbon atoms, and n is 1 to 5 alkyl chains.

7. The negative resist material for the liquid immersion lithography process according to claim 6, wherein said glycoluril derivative having the structure represented by the general formula (1) is butoxymethylated glycoluril.

8. The negative resist material for the liquid immersion lithography process according to claim 1, wherein said resin component is a polymer having at least one monomer unit selected from α-(hydroxyalkyl)acrylic acid and α-(hydroxyalkyl)acrylate ester.

9. The negative resist material for the liquid immersion lithography process according to claim 1, wherein said resin component is a copolymer having at least one monomer unit selected from α-(hydroxyalkyl)acrylic acid and α-(hydroxyalkyl)acrylate ester, and at least one monomer selected from other ethylenic unsaturated carboxylic acid and ethylenic unsaturated carboxylate ester.

10. The negative resist material for the liquid immersion lithography process according to claim 1, wherein said resin component is a polymer having a unit of dicarboxylic acid monoester.

11. The negative resist material for the liquid immersion lithography process according to claim 10, wherein said polymer having the unit of dicarboxylic acid monoester is a copolymer of the unit of dicarboxylic acid monoester with at least one monomer unit selected from α-(hydroxyalkyl)acrylic acid and α-(hydroxyalkyl)acrylate ester, and other ethylenic unsaturated carboxylic acid or ethylenic unsaturated carboxylate ester.

12. The negative resist material for the liquid immersion lithography process according to claim 1, wherein said immersion liquid is water composed of purified water or deionized water.

13. The negative resist material for the liquid immersion lithography process according to claim 1, wherein said immersion liquid is a liquid composed of a fluorine-based solvent.

14. A method for forming a resist pattern using a liquid immersion lithography process comprising:
forming a photoresist film on a substrate using a resist material containing at least a resin component and a crosslinker component which is poorly soluble in a liquid immersion medium;
directly arranging an immersion liquid on said substrate on which said resist film has been laminated;
irradiating predetermined pattern light onto said resist film through said liquid and if necessary giving a baking treatment;
removing said immersion liquid from the resist film after said irradiation; and
developing the resist film fromwhich said liquid has been removed to obtain the resist pattern.

15. The method for forming the resist pattern according to claim 14, wherein said liquid immersion lithography process comprises exposing the resist film to light with the intervening immersion liquid with a predetermined thickness on at least the resist film in a path of lithography exposure light reaching the resist film, a refractive index of said immersion liquid being higher than that of air and lower than that of the resist film, for enhancing a resolution of a resist pattern.

16. The method for forming the resist pattern according to claim 14, wherein said water-poorly soluble crosslinker component has at least three or more crosslink-forming functional groups per molecule, one or less of said functional groups being a crosslink-forming functional group having a nitrogen atom.

17. The method for forming the resist pattern according to claim 16, wherein said water-poorly soluble crosslinker component is a glycoluril derivative.

18. The method for forming the resist pattern according to claim 17, wherein said glycoluril derivative has a structure represented by the following general formula (1): 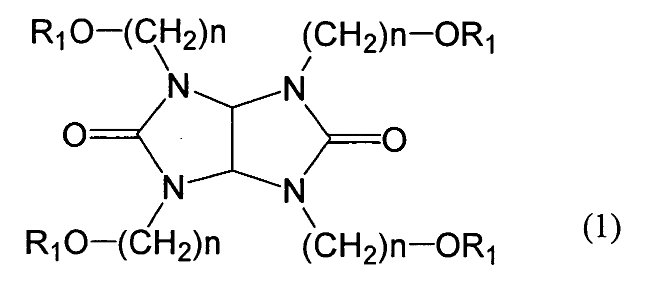 wherein R₁ is an alkyl group having 1 to 10 carbon atoms, and n is 1 to 5 alkyl chains.

19. The method for forming the resist pattern according to claim 18, wherein said glycoluril derivative is butoxymethylated glycoluril.

20. The method for forming the resist pattern according to claim 14, wherein said immersion liquid is water composed of purified water or deionized water.

21. The method for forming the resist pattern according to claim 14, wherein said immersion liquid is a liquid composed of a fluorine-based solvent.
